# EUROPÄISCHE PATENTSCHRIFT

(11) **EP 3 624 986 B1**
(45) Veröffentlichungstag und Bekanntmachung des Hinweises auf die Patenterteilung: **18.08.2021**
(21) Anmeldenummer: 18732635.0
(22) Anmeldetag: 09.05.2018
(51) Int. Cl.: B23K 35/26, B23K 35/30, B23K 35/02

(54) **BLEIFREIE LÖTFOLIE ZUM DIFFUSIONSLÖTEN UND VERFAHREN ZU DEREN HERSTELLUNG**
LEAD-FREE SOLDER FOIL FOR DIFFUSION SOLDERING AND METHOD FOR PRODUCING THE SAME
FEUILLE DE BRASAGE SANS PLOMB DESTINÉE AU BRASAGE-DIFFUSION ET SON PROCÉDÉ DE FABRICATION

(30) Priorität: 15.05.2017 DE 102017004626
(43) Veröffentlichungstag der Anmeldung: 25.03.2020
(73) Patentinhaber: Pfarr Stanztechnik Gmbh, 36419 Buttlar / Thüringen (DE)
(72) Erfinder: DAOUD, Haneen, 95448 Bayreuth (DE); LOIDOLT, Angela, 36404 Völkershausen (DE); REICHELT, Stephan, 36284 Hohenroda (DE)
(86) Internationale Anmeldenummer: PCT/DE2018/000132
(87) Internationale Veröffentlichungsnummer: WO 2018/210361

(56) Entgegenhaltungen:
- WO-A1-2017/077824
- JP-B1- 6 042 577
- US-A1- 2006 186 550
- US-B1- 9 620 434

## Beschreibung

Die Erfindung betrifft eine bleifreie Lötfolie zum Diffusionslöten und das Verfahren zu deren Herstellung, mit welcher metallische Bauteile und/oder metallisierte/metallbeschichtete Bauteile, d.h. metallische Oberflächenschichten benachbarter Bauteile, miteinander verbunden werden können.

Die Zuverlässigkeit von Lötstellen in der Elektronik und dabei insbesondere in der Leistungselektronik erfordert heute sehr gute mechanische, elektrische und thermische Eigenschaften der Lotmaterialien wie auch der mit Ihnen erzeugten Verbindungszonen, wobei deren Beständigkeit gegenwärtig auf immer höhere Temperaturbereiche ausgedehnt werden soll.
Der internationale Trend geht dabei aus Gründen des Umweltschutzes und der Gesundheitsunbedenklichkeit zum Einsatz von umweltfreundlichen und gesundheitsunbedenklichen bleifreien Lotmaterialien.
Im Zuge der Umstellung auf bleifreie Lote wurden zahlreiche Lotvariationen, größtenteils basierend auf Zinn, entwickelt, die im Vergleich zu den bleihaltigen Legierungen zwar auch gute mechanische, elektrische und thermische Eigenschaften aufweisen, jedoch im Bereich von ca. 214°C bis 250°C aufschmelzen, so dass die Beständigkeit ihrer guten Eigenschaften auf Einsatzgebiete bis etwa 150°C beschränkt ist.
Für höhere Arbeits-/Einsatztemperaturen gibt es derzeitig keine bleifreien Lote, die die in der Leistungselektronik geforderte Temperaturbeständigkeit der Eigenschaften mit der notwendigen Zuverlässigkeit und Wirtschaftlichkeit vereinen.
Daher besteht bei Hochtemperaturanwendungen, d.h. insbesondere bei Arbeitstemperaturen auch über 250°C, die Notwendigkeit, neue kostengünstig zu verwendende bleifreie Lotfolien zu entwickeln, die den in der Leistungselektronik benötigten Anforderungen an die Temperaturführung gerecht werden, um einerseits während des Lötprozesses die zu verbindenden Baugruppen nicht zu beschädigen und andererseits, auch unter dem Gesichtspunkt der Wirtschaftlichkeit, eine hochtemperaturbeständige Lotverbindung zu erzielen, die eine hohe thermische Zuverlässigkeit der Verbindungszonen zwischen den benachbarten Bauteilen gewährleistet.
Gegenwärtig wird in der Elektronik und den verwandten Industriezweigen teilweise das kostenintensive eutektische Au80Sn20-Lot mit einer Schmelztemperatur von 280°C eingesetzt.
Eine breite Anwendung dieses Au80Sn20-Lotes, wie beispielsweise zum Löten von Si-Halbleiterschaltkreisen in leistungselektronischen Schaltern ist jedoch aus Gründen der hohen Kosten für das Lotmaterial nicht möglich.
In der US 7659614 B2 wird in diesem Zusammenhang auch das Fügen von mit Gold und/oder Silber beschichteten Substraten und elektronischen Bauteilen unter Verwendung von zinnhaltigen Gold- oder Indiumloten vorbeschrieben. Beim Gebrauch dieser Materialien bilden Gold und/oder Silber aus den Metallisierungsschichten mit Zinn und/oder Indium Verbindungszonen mit höheren Schmelztemperaturen, als die ursprünglich eingesetzten Lote aus. Der Fügeprozess findet bei mindestens 250°C und dauert 10 min bis 30 min, dabei ist jedoch stets ein leichter Anpressdruck notwendig, was den Lötprozess jedoch auch aufwendiger gestaltet.

Daher bleibt der Einsatz dieser im Patent US 7659614 B2 offenbarten Lehre auf Grund des technologischen Aufwandes und der hohen Materialkosten für die Beschichtungen und das Lot für eine großtechnische Anwendung stark begrenzt.
Da in der Industrie bislang keine technisch und wirtschaftlich vertretbare bleifreie Alternative zu den goldhaltigen Legierungen zur Verfügung steht, wurden, trotz des internationalen Bedürfnisses nach umweltfreundlichen und gesundheitsunbedenklichen bleifreien Lotmaterialien, Ausnahmeregelungen erlassen, wonach Blei in hochschmelzenden Loten (d.h. Lötlegierungen auf Bleibasis mit einem Massenanteil von mindestens 85 % Blei) bis heute noch immer zulässig ist, und daher in der Praxis trotz der gesundheitlichen Bedenken und der Bedenken hinsichtlich des Umweltschutzes noch häufig Anwendung findet.
In Folge der zunehmenden Nutzung von Halbleitern mit breitem Bandabstand (Wide-Band Gap-Halbleitern), wie z.B. aus SiC oder GaN, deren Arbeitstemperaturen weit über 200°C ansteigen können, kommt es jedoch verstärkt zu einer Nachfrage nach Lotverbindungen, die den technischen Anforderungen im Bereich der Hochtemperaturanwendungen, d.h. Arbeitstemperaturen im Bereich von 150°C bis 400°C gerecht werden.
Zur Lösung dieses Problems wurde u.a. die Sintertechnik entwickelt, mit deren Hilfe meist silberhaltige Pasten zum Fügen von elektronischen Bauteilen genutzt werden. Im Gegensatz zum Löten ist bei diesem Fügeverfahren jedoch zwingend eine Presskraft erforderlich. Diese zusätzliche technologische Komponente "Presskraft" ist jedoch auch ein wesentlicher Grund dafür, dass sich auch die Sintertechnik bisher nicht großflächig durchsetzen konnte.
Eine weitere Alternative wird mit dem Einsatz von Reaktionsloten aufgetan. Dies sind reaktive Vielschichtsysteme, aufgebaut aus wenige Nanometer dicken Schichten von mindestens zwei verschiedenen Materialien. Nach einer Aktivierung beginnt die Diffusion zwischen den Schichten, welche sich schnell zu einer exothermen Reaktion entwickelt. Diese liefert die zum Schmelzen eines Lotes notwendige Wärme. Dazu müssen sehr dünne (deutlich kleiner 1 µm) Schichten zweier passender Metalle so oft abwechselnd aufeinander abgeschieden werden, dass insgesamt Folien mit einer Gesamtdicke von 40 µm bis 150 µm aufgebaut werden, deren äußere Schichten jedoch aus einem Lot bestehen. Aus diesen geschichteten Folien können Lotformteile vereinzelt werden. Alternativ können diese Metalle auch abwechselnd auf ein zu verlötendes Bauteil abgeschieden werden, wobei die äußere Schicht wiederum ein Lot sein muss. Der Fügeprozess wird durch Zünden der reaktiven Schichten gestartet, die Geschwindigkeit und Wärmemenge kann nur über den Schichtaufbau gesteuert werden, ist also individuell für jede erdenkliche Lötaufgabe schon bei Fertigung der Formteile oder Beschichtung der zu verlötenden Bauteile festzulegen, was für eine breite und universelle Anwendung dieser Technik ein großes Hindernis bedeutet.
Eine Variante der breit angewendeten Technik des Weichlötens stellt das Diffusionslöten dar, welches bei Einsatz der herkömmlichen Technik, allerdings unter Zusatz verschiedener technologischer Schritte, wie die Anwendung äußerer Presskraft oder anschließender Wärmebehandlung oder durch längere Lötprofile, realisiert wird. Im Resultat eines solchen Verfahrens entsteht während des Lötprozesses ein von der ursprünglichen Zusammensetzung des Weichlotes abweichender, die zu fügenden Bauteile fest verbindender Stoff, dessen Schmelztemperatur höher liegt als die des eingesetzten Lötmaterials. Zur Bildung dieses neuen Stoffes, der hochschmelzenden intermetallischen Phase, wird neben dem im Lötmaterial gebräuchlichen niedrig schmelzenden Metall, wie z.B. Zinn, ein weiteres hochschmelzendes Metall, wie beispielsweise Kupfer, benötigt, aus denen sich durch Diffusion ineinander die intermetallischen Phasen aufbauen, deren Schmelzpunkte höher als der des niedrig schmelzenden Metalls sind.
Aus der DE 10 2007 010242 A1 ist ein Verfahren zum Verbinden von zwei Metallschichten mit Hilfe eines Diffusionslötprozesses bekannt. Diese in der DE 10 2007 010242 A1 offenbarte Lösung setzt voraus, dass jede Metallschicht eingangs bereits in besonderer Weise strukturiert ist und mindestens eine davon zusätzlich mit einer Lotschicht versehen sein muss. Nur diese ganz spezielle, den jeweiligen zu fügenden Komponenten angepasste Ausführung der Schichten gewährleistet dann die Ausbildung einer kompakten, richtig platzierten Verbindungszone aus einer solchen intermetallischer Phase, ohne dass während des Lötprozesses wiederum eine zusätzliche Presskraft ausgeübt werden müsste. Daher ist auch diese in der DE 10 2007 010242 A1 offenbarte Lösung nur auf ganz spezielle Anwendungen, wie beispielsweise das Löten von Chips auf Wafer, beschränkt.
Aus der US 8348139 B2 sind auch mehrschichtige Lötfolien zum Diffusionslöten bekannt, welche aus einem metallischen Kern aufgebaut sind, der aus reinen Metallen oder deren Legierungen mit einem Schmelzpunkt von höher als 280°C besteht, und der beidseitig mit gleichartigen oder verschiedenen Schichten, bestehend aus Zinn- oder Indiumbasisloten, verbunden ist, wobei die Dicke der eingesetzten Lotschichten mindestens 5 µm beträgt.
Bei diesen mehrschichtigen Lötfolien nach der US 8348139 B2 wird der Diffusionslötprozess bei 300°C bis 380°C in 5 min bis 8 min ausgeführt. Nachfolgend muss, um eine durchgängige Schicht der intermetallischen Phasen zu gewährleisten, jedoch noch eine Wärmebehandlung der gefügten Komponenten durchgeführt werden. Bei dieser Lösung bleibt nach der Wärmebehandlung noch eine nicht näher definierte Schichtdicke des metallischen Kernmaterials erhalten.
Weiterhin sind auch aus der US 2006 186550 A mehrschichtige Lötfolien für das Diffusionslöten bekannt, welche aus einem metallischen Kern, der aus Ag, Au, Cu, oder Ni sein kann, auf dem beidseitig Schichten, bestehend aus Zinn-, Indium- oder Bismuthbasisloten, aufgetragenen sind. Während des Diffusionslötprozesses schmelzen die beiden Weichlotschichten und reagieren mit dem vollflächigen Kernmaterial. Gemäß der Lösung nach US 2006186550 A sind die aufgetragenen Schichten 1 µm bis maximal 20 µm dick, damit innerhalb einer sinnvollen Dauer des Lötprozesses (von etwa 10 min bei 240°C) die Umwandlung der flüssigen Phase in intermetallische Phasen so weit realisiert ist, dass die Haftung der gelöteten Komponenten in einem nachfolgenden Prozessschritt bei 260°C gewährleistet bleibt.
Der Diffusionslötprozess selbst, wie auch die Zuverlässigkeit der entstandenen Verbindungsschicht, wurde auch in Veröffentlichungen untersucht, unter anderem von N. Oeschler und C. Ehrhardt (N. Oeschler et al.: Diffusionslöten-Technologie für hochzuverlässige Chip-Substrat-Verbindungen, Weichlöten 2013, DVS-Berichte Band 290, S. 55-61 und C. Ehrhardt et al.: Prüfverfahren der Verbindungstechnik von Leistungselektronischen Modulen, Weichlöten 2013, DVS-Berichte Band 290, S. 43-51). Die in diesen Veröffentlichungen beschriebenen Ergebnisse sind nur für mit Kupfer/Zinn beschichtete Halbleiter - Substratverbindungen und waren auch nur unter Anwendung einer Presskraft zu erzielen.
In der US 9620434 B1 wird ebenfalls das Fügen von Leistungselektronikbauteilen, mittels Diffusionslöten vorbeschrieben, welches für Arbeitstemperaturen von über 250°C geeignet ist. Hierzu werden zwei Schichtsysteme, bestehend jeweils aus einer hoch- und einer niedrigschmelzenden Metallschicht, die auf die zu verbindenden Komponenten platziert werden eingesetzt. Gegebenenfalls wird das Gesamtsystem auch unter Zugabe von hoch- und niedrigschmelzenden Metallpartikeln zwischen den Metallschicht aufgebaut und nachfolgend erwärmt. Der Nachteil dieser Lösung besteht darin, dass die vollständige Umwandlung der flüssigen Phase des Lotmaterials in intermetallische Verbindungen / intermetallische Phasen nur durch eine deutliche Verlängerung der herkömmlichen Lötzeiten möglich ist, d.h. bei Einsatz der Lösung nach der US 9620434 B1 erfordert zwingend eine Prozessdauer von über 30 Minuten.
Gemäß der US 2017/0080662 A1 wird zum Verbinden von Substraten, hier insbesondere von Bauteilen der Leistungselektronik, welche thermischen Zyklen mit Arbeitstemperaturen von über 250°C ausgesetzt sind, eine Verbundverbindungschicht eingesetzt, die eine innere Verbindungsregion und eine äußere Bindungsregion aufweist, die um die innere Bindungsregion herum positioniert ist, wobei das Material der inneren Bindungsregion einen größeren Elastizitätsmodul als das Material der äußeren Bindungsregion aufweist; mit einer Metallmatrix, wobei ein Teil der Metallmatrix in der äußeren Bindungsregion und ein Teil der Metallmatrix im Innenbindungsbereich positioniert ist, wobei der Elastizitätsmodul der Metallmatrix größer als der Elastizitätsmodul der Weichmaterialelemente, aber kleiner als der Elastizitätsmodul der Hartmaterialelemente ist. Der Fokus dieser in der US 2017/0080662 A1 vorgestellten Lösung liegt auf dem Ausgleich von Spannungen zwischen Materialien mit unterschiedlichen Wärmeausdehnungskoeffizienten.
Ein Sonderfall dieses als Komposite - Fügeschicht bezeichneten mittleren Substrates beinhaltet auch eine Diffusionslotverbindung. Da jedoch in der Beschreibung der vg. Erfindung keine Angaben zum Fügeprozess und zur Fügedauer sowie zum Aufbau der erzielten Fügestelle gemacht werden, ist auch bei dieser Lösung von einer im Stand der Technik üblichen Lötprozessdauer, d.h. von einer Lötprozessdauer von über 30 Minuten auszugehen, die gemäß dem Stand der Technik erforderlich ist, um eine vollständige Umwandlung des flüssigen Lotmaterials in intermetallische Phasen zu erzielen.
Aus einer weiteren Veröffentlichung, der von A. Syed-Khaja (A. Syed-Khaja et al.: Process optimization in transient liquid phase soldering (TLPS) for an efficient and economical production of high temperature power electronics, CIPS 2016, S. 187-193), ist der Einsatz von jeweils einem einzelnen Lotformteil aus herkömmlichen Lotlegierungen zum Diffusionslöten von Substraten mit einem Halbleiterbaustein bekannt. In dieser Veröffentlichung wird dargelegt, dass der Einsatz von dünnen Lotformteilen (25 µm) eines herkömmlichen SnCu-Lotes, mit nicht mehr als 3% Kupfer, ohne Anwendung von Presskraft zu einer vollständigen Ausbildung der hochschmelzenden intermetallischen Verbindungszone führt, allerdings sind hierfür etwas längere Lötzeiten und mindestens ein mit Kupfer metallisiertes Bauteil mit angepasster Rauheit erforderlich. Beim Einsatz von Lotformteilen, bestehend aus beidseitig mit reinem Zinn plattiertem Kupfer (Sn20µm/Cu35µm/Sn20µm) wurde jedoch nur eine teilweise Umwandlung in eine hochschmelzende Phase erreicht, d.h. es verblieb ein Weichlotanteil mit entsprechend niedriger Schmelztemperatur in der Verbindungszone. Nur bei Verwendung von mit Kupfer metallisierten Bauteilen verlief diese Umwandlung vollständig. Alle Ergebnisse wurden nur nach einer Lötzeit von 22 min bei einer Temperatur von 260°C mit Bauteilen einer angepassten Rauheit erreicht.
In der Veröffentlichung "Prüfverfahren der Verbindungstechnik von Leistungselektronischen Modulen", Weichlöten 2013, DVS-Berichte Band 290, S. 43-51 beschreibt C. Ehrhardt et al, dass herkömmliche bleifreie Lotpasten, wie z.B. SnAgCu, zur Realisierung des Diffusionslötprozesses zusätzlich mit hochschmelzenden Pulvern, wie beispielsweise Kupfer, homogen vermischt werden müssen. Hierbei löst das geschmolzene Zinnbasislot der bleifreien Lotpaste das Kupferpulver und es konnten die intermetallischen Phasen Cu6Sn5 und Cu3Sn ausgebildet werden. Unter Einsatz dieser mit hochschmelzenden Pulvern vermischten bleifreifreien Lotpasten wandelte sich die flüssige Phase im Diffusionslötprozess unter Anwendung einer Presskraft komplett in intermetallische Phasen um. Die Schmelzpunkte der beiden so gebildeten Phasen liegen bei 415°C bzw. bei 676°C. Deren porenfreie Ausbildung ist jedoch neben der Presskraft während des Lötprozesses an eine sehr homogene Vermischung der beiden benötigten Komponenten, Lötpaste und Pulver, gebunden.
In der Patentschrift EP 1337376 B1 wird eine Lötpaste beschrieben, die als Lötmittel eingesetzt wird. Diese Lötpaste enthält zusätzlich zum Lotmaterial mit Metall überzogene isolierende Kerne, welche eine hohe Schmelztemperatur aufweisen. Gemäß der Lösung nach der EP 1337376 B1 reagiert das Lotmetall während des Lötprozesses vollständig mit der Metallisierung der Kerne und bildet basierend auf dem Diffusionslötprozess intermetallische Phasen, welche dann die hochschmelzenden Kerne umschließen. Die entstehende Lötnaht weist eine insgesamt heterogene Struktur auf, was sich negativ auf die Wärmeleitfähigkeit der mit dieser Lösung erzielten Verbindungszone auswirkt.

In der WO 96/19314 wird ein Pulvergemisch vorbeschrieben bei dem das Lotmetall aus hoch- und niedrigschmelzender Metallkomponenten besteht, deren körnige oder plättchenförmige Füllkomponenten als Zusatz beigemischt sind. Generell sind Metallpulver oder auch Metallgranulate sehr teuer in der Herstellung und weisen zudem eine große Streubreite in den Abmessungen auf, so dass zudem Klassierungsprozesse zwischengeschaltet werden müssen, darüber hinaus ist eine homogene Durchmischung von Metallpulver nicht unproblematisch und daher sehr aufwendig. Das Pulvergemisch selbst soll dann, gemäß der WO 96/19314, vorzugsweise als Suspension mit flüssigem organischen Lösemittel oder als Paste eingesetzt werden. Eine in diesem Zusammenhang Anwendung findende Füllkomponente hat dabei die Aufgabe, die Dicke der sich während des Diffusionslötens ausbildenden intermetallischen Phasen auf wenige µm zu begrenzen. Sie muss deshalb je nach Benetzbarkeit mit entsprechenden, die Anbindung fördernden oder bremsenden Überzügen versehen, und mit den Metallkomponenten sehr homogen vermischt werden. In speziellen Ausführungsformen / Sonderbauformen kann gemäß der WO 96/19314 das o.g. aus Pulvern bestehende Lotmetall auch zu Folien gepresst werden, aus denen dann Lotformteile ausgestanzt werden, die zwischen die zu verbindenden Objekte gelegt werden. Die Herstellung derartiger Folien mit einer homogenen Verteilung der eingesetzten Pulver, d.h. die Pulvermetallurgie ist sehr aufwändig und kostenintensiv, wobei beim Verpressen, d.h. im pulvermetallurgischen Verfahren, die theoretische Dichte nicht oder nur sehr schwer, d.h. mit hohem Kostenaufwand, erreichbar ist.
Der Nachteil aller Ausführungsformen dieser Lösung nach der WO 96/19314 ist, dass zusätzlich zu den beiden oben beschriebenen Metallkomponenten eine Füllkomponente erforderlich ist, um die gewünschten intermetallischen Phasen zu erzielen. Zudem ist gemäß der Beschreibung zu dieser Lösung auch bei dieser Lösung eine Lötprozessdauer von über 30 Minuten erforderlich, um eine vollständige Umwandlung des flüssigen Lotes in intermetallische Phasen zu erreichen, bzw. alternativ ein nachgeschalteter Temperprozess.

Zur besseren Benetzung der Oberflächen wird zudem beim Lötvorgang die Zugabe eines Flussmittels als vorteilhaft erachtet. Dieses Flussmittel hat jedoch im Hinblick auf die Arbeitssicherheit und den Gesundheitsschutz den Nachteil, dass gemäß der Beschreibung in der WO 96/19314 organische Säure entsteht, welche im Nachgang an den Lötprozess zwingend in einem zusätzlichen Arbeitsgang entfernt werden muss.

Weitere Lösungen in denen ebenfalls aus Pulvern bestehendes Lotmetall, mit all den oben beschrieben Nachteilen, entweder direkt zu Lötfolien verpresst, oder auch zwischen zwei benachbarten Folien eingebettet wird, sind beispielsweise aus der JP 6042577 B1, (EP 3266 558 A1), der WO 2017/077824 A1, (US 2018/126494 A1) wie auch aus der US 9,62,434 B1 bekannt.

Zusammenfassend ist daher festzustellen, dass die derzeitig in der Leistungselektronik und für andere Einsatzgebiete genutzten kostengünstigen bleifreien Weichlote nur einen Einsatztemperaturbereich bis etwa 150°C abdecken können. Für den Einsatztemperaturbereich der gelöteten Bauelemente höher 150°C gibt es zu den goldhaltigen Lotlegierungen bislang keine technisch und wirtschaftlich vertretbare bleifreie Lotalternative, welche die in der Leistungselektronik geforderte Temperaturbeständigkeit mit der erforderlichen Zuverlässigkeit mit einer vertretbaren Wirtschaftlichkeit, d.h. innerhalb kurzer, d.h. für das Weichlöten typischen Lötzeiten, und ohne zusätzliche Prozessparameter, wie beispielsweise einer zusätzlichen Presskraft oder einer zusätzlichen, nachfogenden Wärmebehandlung, vereinen.

In diesem Zusammenhang besteht daher die Notwendigkeit, neue bleifreie Lote, möglichst als Lötfolie bereitzustellen, so dass diese dann auch in Form von Lotformteilen kostengünstig technologisch einsetzbar sind.

Aufgabe der Erfindung ist es daher, eine wirtschaftlich vertretbare, umweltfreundliche und gesundheitsunbedenkliche, bleifreie Lötfolie zum Diffusionslöten und ein Verfahren zu deren Herstellung zu entwickeln, welche mit einem für das Weichlöten typischen Lötprofil, d.h. bei Vermeidung langer Lötzeiten, wie auch ohne eine anschließende Wärmebehandlung und ohne die Ausübung einer Presskraft während des Lötens, bei gleichzeitiger Vermeidung der Ausbildung von Poren, die metallischen / metallisierten Oberflächenschichten der zu verlötendenden Bauteile so miteinander verbinden soll, dass eine hochschmelzende Verbindungszone mit einer Wiederaufschmelztemperatur von höher als 400°C entsteht, wobei mittels der zu entwickelnden bleifreien Lötfolie zudem selbst elektrisch leitende Bändchen im Verbindungsbereich beschichtet werden können sollen, so dass im Verbindungsbereich der Bändchen die Wiederaufschmelztemperatur der nach dem Lötprozess gebildeten hochschmelzenden Verbindungszone höher als 400°C ist, und zudem für spezielle Anwendungen, in einer Sonderbauform, die bleifreie Lötfolie auch mit einem angepassten, resultierenden, thermischen Ausdehnungskoeffizienten versehen sein soll, um durch das Löten eingebrachte, wie auch während des Bauteileinsatzes entstehende thermische Spannungen aufzunehmen, und zudem gleichzeitig die mechanische Flexibilität der nach dem Lötprozess entstehenden Verbindungszone zu erhöhen. Die Erfindung ist in den beigefügten Ansprüchen definiert.

Erfindungsgemäß wird diese Aufgabe durch eine bleifreie Lötfolie 1 zum Diffusionslöten und ein Verfahren zu deren Herstellung gelöst, mittels der metallische Bauteile 2 und/oder metallisierte/metallbeschichtete Bauteile 2, d.h. metallische Oberflächenschichten 3 benachbarter Bauteile 2, miteinander verbunden werden können, und die sich dadurch auszeichnet, dass die bleifreie Lötfolie 1 kompakt als Lotverbundwerkstoff 4 so aufgebaut ist, dass in einer bleifreien Weichlotumgebung, einer Weichlotmatrix 5, Partikel 6 einer hochschmelzenden Metallkomponente 7, einer Hartlotkomponente, dispers verteilt so angeordnet sind, dass jeder der Partikel 6 vollständig vom bleifreien Weichlot 8 umgeben ist, um in einem gebräuchlichen Weichlötprozess eine vollständige Umwandlung des Weichlotes 8 der Weichlotmatrix 5 in intermetallische Phasen 9 zu bewirken, welche eine Schmelztemperatur von höher als 400°C aufweisen.

Die erfindungsgemäße kompakte, als fester Verbund hergestellte, bleifreie Lötfolie 1 beinhaltet alles für den Aufbau der hochschmelzenden intermetallischen Phase erforderliche Material, wobei die erfindungsgemäße Verteilung des für den Aufbau der hochschmelzenden intermetallischen Phase benötigten Materials in Verbindung mit der erfindungsgemäßen kompakten Ausführung, als Lötfolie 1, bewirkt, dass in einem Bleifrei-Weichlötprozess bei Temperaturen von ca. 240°C eine sehr schnelle und porenfreie Ausbildung einer hochschmelzenden intermetallischen Verbindungszone 16 mit Wiederaufschmelztemperaturen von über 400°C erzielt wird.

Erfindungswesentlich ist in diesem Zusammenhang, dass die in der Weichlotmatrix 5 dispers verteilten Partikel 6 der hochschmelzenden Metallkomponente 7 in Richtung der Folienstärke eine Dicke von 3 µm bis 20 µm aufweisen, wobei die Abstände der Partikel 6 zueinander in der Weichlotmatrix 5 1 µm bis 10 µm betragen, und jeder der Partikel der hochschmelzenden Metallkomponente 7 allseitig von einer 1 µm bis 10 µm starken Schicht des bleifreien Weichlotes 8 umhüllt ist.

Mittels der erfindungsgemäßen bleifreien kompakten Lötfolie 1 mit in einer Weichlotmatrix 5, Weichlotumgebung, angeordneten Partikel 6 aus Hartlot (Hartlotpartikel) in Verbindung mit deren dispersen Verteilung und dabei gleichzeitig kompakten Einbettung in der Weichlotmatrix 5, wird in einem für das Bleifrei-Weichlöten typischen Prozessgebiet, ohne lange Lötzeiten, wie auch ohne anschließende Wärmebehandlung, und ohne die Ausübung einer Presskraft ein Diffusionslöten bewirkt, welches gleichzeitig die Ausbildung von Poren vermeidet, und die metallischen / metallisierten Oberflächenschichten 3 der zu verlötendende Bauteile 2, so miteinander verbindet, dass zwischen den zu fügenden Bauteilen 2 eine durchgängige porenfreie Schicht einer hochschmelzenden Verbindungszone 16 in Form einer intermetallischen Phase 9 entsteht, deren Wiederaufschmelztemperatur über 400°C liegt.

Kennzeichnend ist dabei, dass der Weichlotanteil, die Weichlotmatrix 5, im Verhältnis zum Anteil an hochschmelzender Metallkomponente 7 nicht höher liegt, als dies in den aufzubauenden intermetallischen Phasen 9 erforderlich ist. Dieses Verhältnis des prozentualen Anteils der in dem Lotverbundwerkstoff 4 angeordneten Partikel 6 der hochschmelzenden Metallkomponenten 7 zum prozentualen Anteil des Weichlotes 8, der die Partikel 6 umgebenden bleifreien Weichlotmatrix 5, wird nach der stöchiometrischen Formel der aus den jeweiligen Ausgangsmaterialien zu bildenden intermetallischen Phasen 9 so ermittelt, dass stets alles Weichlot 8 der bleifreien Weichlotmatrix 5 in die jeweils aufzubauenden intermetallischen Phasen 9 umgewandelt wird.

Das Verhältnis des Weichlotanteils zum Anteil der Partikel 6 an hochschmelzender Metallkomponente 7 in der Weichlotmatrix 5 hängt somit von der stöchiometrischen Formel der jeweils auszubildenden intermetallischen Phase 9 ab. Erfindungsgemäß wäre dies bei Verwendung der Sn / Cu - Kombination mit 50% Sn, das CuSn3 und Cu6Sn5.

Ausschlaggebend für eine Wiederaufschmelztemperatur von höher als 400°C ist, dass stets die gesamte Weichlotmatrix 5 umgewandelt wird, ansonsten hätte man noch Bereiche in der Verbindungszone 16, die eine niedrigere Schmelztemperatur hätten, und das ist aufgabengemäß nicht erwünscht.

Bei einer anderen Kombination, erfindungsgemäß bei Verwendung der Sn / Ni - Kombination mit 43% Sn, bilden sich als intermetallische Phasen Ni3Sn4 aus.

In diesem Zusammenhang ist aber auch festzustellen, dass nach dem Lötprozess noch Partikel 6 von der hochschmelzenden Metallkomponente in der Verbindungszone 16 verbleiben können, und die Wiederaufschmelztemperatur dennoch höher als 400°C bleibt.

Über diesen höheren Anteil der Partikel 6, d.h. mittels des hochschmelzenden Restmetalls, welches nach dem Lötprozess als Inseln, z.B. aus Kupfer, in der intermetallischen Phase 9 eingelagert ist, hat man die Möglichkeit, die mechanischen, elektrischen und wärmeleitenden Eigenschaften der nach dem Lötprozess erzielten Verbindungszone 16 zu beeinflussen.

Nach der erfindungsgemäßen Lehre ist es daher nur ausschlaggebend, dass die gesamte Weichlotkomponente im Lötprozess verbraucht, in intermetallische Phasen 9 umgewandelt werden muss, um nach dem Lötprozess eine Wiederaufschmelztemperatur von höher als 400°C zu gewährleisten.

Beispielsweise würde bei Verwendung einer In / Ag - Kombination zur Erreichung einer Wiederaufschmelztemperatur von höher als 400°C ein sehr hoher Silberanteil erforderlich sein. Da es jedoch die Aufgabe Erfindung ist, eine wirtschaftlich vertretbare, bleifreie Lötfolie zum Diffusionslöten zu entwickeln, wird diese Kombination nicht näher in die Betrachtung einbezogen.

Wesentlich ist auch, dass die Gesamtdicke der bleifreien Lötfolie 1 entsprechend den technologischen Rahmenbedingungen / gewünschten Eigenschaften der Verbindungszone 16 20 µm bis 0,5 mm beträgt.

Kennzeichnend ist weiterhin, dass die Lötfolie 1, der Lotverbundwerkstoff 4, eine den metallischen Oberflächenschichten 3 der zu fügenden Bauteile 2 benachbarte äußere Mantelschicht 10 aufweist, deren Schichtdicke von 2 µm bis 10 µm beträgt, und die aus Weichlot 8 besteht.

Diese aus Weichlot 8 bestehende Mantelschicht 10 dient während des Lötprozesses dazu, die zu fügenden Oberflächen / Oberflächenschichten 3 der benachbarten Bauteile 2 vollständig zu benetzen, und mit diesen Metallisierungen (z.B. Cu, Ni, Ni(P), Ni(Ag)) der Oberflächen der zu fügenden Bauteile 2 intermetallische Phasen 9 auszubilden.

Diese bleifreie Lötfolie 1 zum Diffusionslöten ermöglicht mit einem für das bleifreie Weichlöten typischen Lötprofil, beispielsweise bei Einsatz von Lötfolien 1 der Dicke von 30 µm bis 250 µm bei einer Löttemperatur von ca. 240°C und bei Lötzeiten von unter 5 min, ohne jegliche anschließende Wärmebehandlung, wie auch ohne die Ausübung einer Presskraft während des Lötens, bei gleichzeitiger Vermeidung der Ausbildung von Poren, dass die metallischen / metallisierten Oberflächenschichten 3 der zu verlötendenden Bauteile 2, so miteinander verbunden werden, dass eine durchgängige Schicht einer hochschmelzenden Verbindungszone 16 in Form einer intermetallischen Phase 9 entsteht, welche eine Wiederaufschmelztemperatur von höher als 400°C aufweist.

Erfindungswesentlich ist auch, dass die bleifreie Lötfolie 1 zum Diffusionslöten entsprechend spezieller technischer oder auch technologischer Anforderungen, wie aber auch aus wirtschaftlichen Gründen als Mehrschichtlötfolie 11 aufgebaut ist, wobei die einzelnen Schichten der Mehrschichtlötfolie 11 abwechselnd aus dem oben beschriebenen Lotverbundwerkstoff 4 und aus 2 µm bis 100 µm starken Schichten einer hochschmelzenden Metallkomponente 7, einer Zwischenschicht 23, bestehen, wobei auch die Mehrschichtlötfolie 11 wiederum eine den metallischen Oberflächenschichten 3 der zu fügenden Bauteile 2 benachbarte äußere Mantelschicht 10 aufweist, deren Schichtdicke von 2 µm bis 10 µm beträgt, und die aus Weichlot 8 besteht, und die Gesamtdicke der Mehrschichtlötfolie 11 von 40 µm bis 1,0 mm beträgt.

Mittels dieser Sonderbauform, der Mehrschichtlötfolie 11, kann die bleifreie Lötfolie 1 auch mit einem angepassten, resultierenden, thermischen Ausdehnungskoeffizienten versehen werden, um durch das Löten eingebrachte, wie auch während des Bauteileinsatzes entstehende thermische Spannungen aufzunehmen, und zudem gleichzeitig die mechanische Flexibilität der nach dem Lötprozess entstehenden Verbindungszone zu erhöhen.

Wesentlich ist auch, dass die bleifreie Lötfolie 1 zum Diffusionslöten sowohl als Lotverbundwerkstoff 4, wie aber auch als Mehrschichtlötfolie 11 in der Bauform eines Lotformteil 12 eingesetzt werden kann, um in einem Bleifrei-Weichlötprozess zwischen metallischen Oberflächen / Oberflächenschichten 3 als Diffusionslot zu fungieren und die benachbarten Bauteile 2 so miteinander zu verbinden, dass die Wiederaufschmelztemperatur höher als 400°C ist.

Die Lotformteile 12 werden durch Schneid- oder Stanz- oder auch durch Stanz-Biegeprozesse aus der Lötfolie 1 in die gewünschte Formteil-Geometrie gebracht und sind somit universell in vielen gebräuchlichen Weichlötprozessen einsetzbar, die allein durch die Verwendung der verteilten Partikel 6 des Lotverbundwerkstoffs 4 (Kompositematerials) zu Diffusionslötprozessen werden. Auf diesem Weg wird die Wiederaufschmelztemperatur der Verbindungszonen gegenüber konventionell mit Weichlot gelöteten Bauteilen wesentlich angehoben. Bei Einsatz von Zinn-Weichlotkomponente und Kupfer als hochschmelzende Metallkomponente werden die mit Lotformteilen 12 aus Lotverbundwerkstoff 4 gelöteten Bauelemente 2 für den Einsatztemperaturbereich bis 400°C einsetzbar, wobei die in der Leistungselektronik geforderte Temperaturbeständigkeit der Eigenschaften mit der notwendigen Zuverlässigkeit und Wirtschaftlichkeit vereint wird.

Kennzeichnend ist auch, dass ein metallisches Leiterband 13, welches im zu fügenden Produkt 14 als elektrischer Leiter dient, an den Fügestellen 15 mit der bleifreien Lötfolie 1 sowohl in der Ausführungsform als Lotverbundwerkstoff 4 wie aber auch in der Ausführungsform als Mehrschichtlötfolie 11 partiell beschichtetet ist, damit nach dem Weichlötprozess das partiell beschichtete Leiterband 13 die benachbarten Bauteile 2 so miteinander verbindet, dass nach dem Weichlötprozess eine Verbindungszone 16 zwischen dem beschichteten Leiterband 13 und den mit diesem zu verbindenden Bauteilen 2 entsteht, welche eine Wiederaufschmelztemperatur von höher als 400°C aufweist.

Hierbei wird die erfindungsgemäße zum Diffusionslöten hergestellte bleifreie Lötfolie 1 einseitig durch partielles Plattieren auf ein elektrisch gut leitendendes Material, wie beispielsweise Kupfer oder Aluminium, aufgebracht. Aus diesem partiell plattierten Material können dann Leiterbänder 13 gefertigt werden, die z.B. anstelle des gebräuchlichen Bonddrahtes zum Aufbau von Leistungsmodulen verwendbar sind.

Die erfindungsgemäße bleifreie Lötfolie 1 zum Diffusionslöten wird erfindungsgemäß wie nachfolgend beschrieben durch Walzplattieren hergestellt.

Entsprechend der vorgesehenen/beabsichtigten prozentualen Zusammensetzung werden Weichlot- und Metallkomponenten mittels Walzplattieren abwechselnd zu einem Schichtverbund gefügt, wobei die Metallkomponente beidseitig mit der Weichlotkomponente plattiert wird.

Das Plattieren wird so begonnen, dass die einzusetzenden Schichtdicken der Komponenten insgesamt so im Verhältnis zueinander stehen, dass im späteren Lötprozess der Weichlotanteil erfindungsgemäß vollständig in die intermetallische Phase eingebaut wird.

Im Anschluss erfolgen dann weitere Walzplattierschritte, bei denen das jeweils plattierte Material mit sich selbst plattiert wird, so dass sich die Zahl der Schichten im Material erhöht, deren Stärke jedoch gleichzeitig reduziert wird. Die Anzahl der notwendigen Plattierschritte bis zum fertigen erfindungsgemäßen Lotverbundwerkstoff 4 ist abhängig von der gewählten Werkstoffkombination aus Weich- und Hartlotkomponente und der gewünschten Gesamtdicke für die Lotformteile. Durch das erfindungsgemäße vielfach wiederholte Plattieren des Schichtverbundes erfolgt eine Durchmengung der Einzelkomponenten im festen Zustand dergestalt, dass durch Aufreißen der Schichten einer der beiden Komponenten deren Bruchstücke in der anderen, der weicheren Komponente dispergiert werden.

Die erfindungsgemäß so entstandene Struktur mit den erfindungsgemäßen Partikelabständen kleiner oder gleich 10 µm gewährleistet die erfindungsgemäß zu erzielenden kurzen Diffusionswege, welche im späteren Bleifrei-Weichlötprozess in Verbindung mit weiteren, nachfolgend noch erläuterten Merkmalen der erfindungsgemäß hergestellten Lötfolie in kurzer Zeit zur vollständigen Umwandlung der Weichlotkomponente in die intermetallische Phase führen und eine kompakte, porenfreie hochschmelzende Verbindungszone entstehen lassen.

Die erfindungsgemäß erzielten kurzen Diffusionswege ermöglichen, in Verbindung mit weiteren, nachfolgend noch erläuterten Vorteilen/Merkmalen der erfindungsgemäßen Lötfolie, sogar die Anwendbarkeit gebräuchlicher Weichlötprofile mit den für diese charakteristischen kurzen Lötzeiten.

Erfindungsgemäß bilden sich dabei intermetallische Phasen 9 aus einer niedrigschmelzenden Weichlotkomponente und einer hochschmelzenden Metallkomponente / Hartlotkomponente, die in den ihrer stöchiometischen Formel entsprechenden Massenanteilen verbraucht werden, aus. Die Komponenten werden/sind so gewählt, dass der Schmelzpunkt ihrer intermetallischen Phase zwischen den Schmelzpunkten der beiden eingesetzten Komponenten liegt.

Die Schmelztemperatur der Weichlotkomponente liegt bei Verwendung von Zinn als Basis im Bereich bis 240°C, während die Schmelztemperatur der intermetallischen Phasen 9 bei Verwendung von Kupfer als hochschmelzende Metallkomponente über 400°C liegt.

Der durch mehrfache Umformprozesse entstandene Lotverbundwerkstoff 4 kann bei Bedarf auch in weiteren Plattierschritten auf ein hochschmelzendes metallisches Basismaterial aufgebracht werden, wodurch sich Schichten von Lotverbundwerkstoff 4 und metallischen Zwischenschichten 23 mit speziellen gewünschten mechanischen Eigenschaften abwechseln und dadurch eine Mehrschichtlötfolie 11 aufgebaut wird, wobei aber eine Weichlotkomponente als äußere Mantelschicht 10 stets die beiden äußeren Schichten bildet.

Eine solche Mehrschichtlötfolie 11 kann dann beispielsweise mit einem angepassten, resultierenden, thermischen Ausdehnungskoeffizienten durch das Löten eingebrachte, wie auch während des Bauteileinsatzes entstehende thermische Spannungen aufnehmen.

Die Dicke der Lötfolie 1 in der Ausführungsform als Lotverbundwerkstoff 4 ist dabei durch die Ausgangsdicken der beiden Komponenten, die Anzahl der Plattierschritte und die abschließenden Walzschritte stets auf die genaue Stärke der Lötfolie 1 bzw. der daraus herzustellenden Lotformteile 12 einstellbar.

Auch die Dicke der Lötfolie 1 in der Ausführungsform als Mehrschichtlötfolie 11 ist durch die Ausgangsdicken der metallischen Zwischenschicht sowie der Schichten mit Lotverbundwerkstoff 4, die Anzahl der Plattierschritte und die abschließenden Walzschritte auf das jeweils gewünschte genaue Maß der Lötfolie 1 bzw. der daraus herzustellenden Lotformteile 12 einstellbar. Erfindungsgemäß ist die hochschmelzende Metallkomponente / Hartlotkomponente mit Partikelabständen kleiner oder gleich 10 µm in der Weichlotkomponente dispergiert.

Die äußeren Schichten der erfindungsgemäßen bleifreien Lötfolie werden erfindungsgemäß, wie bereits erläutert, stets durchgängig von der Weichlotkomponente gebildet.

Durch die erfindungsgemäße Herstellung der bleifreien Lötfolie im Rahmen eines Walzplattierprozesses werden zudem auch die Nachteile bei Einbringen von Partikel in eine Schmelze vermieden, die insbesondere in der Erzielung einer homogenen Verteilung bestehen. Im Prozess des Rührens ist zwar eine homogene Verteilung noch zu gewährleisten, doch beim Erstarren ist dies nicht mehr der Fall.

So ist beim Gießen in die Endform eine homogenen Verteilung der Partikel nicht mehr zu gewährleisten. d.h. wo "wandern" die Partikel hin ?

Auch findet beim Einbringen der Partikel, beispielsweise in die Schmelze, wegen der zwingend erforderlichen (hohen) Temperaturen, zudem bereits eine teilweise Diffusion statt.

Auch diese Probleme die beim Einbringen von Partikeln in eine Schmelze auftreten, werden durch den erfindungsgemäß Anwendung findenden Prozess des Walzplattierens, einem schnellen, effizienten und prozesssicher zu beherrschenden Verfahren, welches bei vergleichsweise niedrigen Temperaturen (d.h. es handelt sich beim Walzplattieren um ein Kaltwalzverfahren, bei dem die Walzen nicht künstlich erhitzt werden) erfolgt, vermieden, so dass durch den erfindungsgemäßen Herstellungsprozess selbst eine ungewollte Diffusion der Materialien ausgeschlossen werden kann.

Die einzelnen Schichtdicken, wie auch die Größe und die Verteilung der ausgebildeten Partikel zur späteren vollständigen Umwandlung des flüssigen Lotmaterials in intermetallische Phasen im Rahmen des erfindungsgemäßen Diffusionslötprozesses, werden durch den Walzplattierungsprozess, erfindungsgemäß wie oben beschrieben, exakt beherrscht.

Im Wege des Walzplattierens kann erfindungsgemäß eine stoffschlüssige Verbindung zwischen den zu plattierenden Partnern optimal hergestellt werden.

So entsteht erfindungsgemäß ein idealer Ausgangszustand für den Diffusionsprozess schon vor dem Aufschmelzen des Weichlotes.

Zudem ist die Herstellung des erfindungsgemäßen Materialverbundes durch das Walzplattierverfahren vergleichsweise sehr kostengünstig.

Die verschiedenen Materialien werden erfindungsgemäß beim Walzplattierverfahren in einem Prozessschritt miteinander verbunden und sodann erfindungsgemäß, entsprechend der jeweils gewünschten Anwendung, im Hinblick auf das erfindungsgemäß gewünschte Volumen und die Dicke der einzelnen Komponente, "modifiziert", d.h. zerkleinert, dabei "ummantelt" und zudem gleichzeitig, wie nachfolgend erläutert, energetisiert.

Der Vorteil des erfindungsgemäß so hergestellten Lotverbundwerkstoffes besteht insbesondere auch darin, dass in Verbindung mit dem hohen Eintrag von mechanischer Energie, während des Arbeitsprozesses des Walzplattierens, sich auch die Bindungsfähigkeit aller Bestandteile des so hergestellten erfindungsgemäßen Lotverbundwerkstoffes deutlich verbessern, so dass in Verbindung mit den anderen Merkmalen des hier vorgestellten erfindungsgemäßen Lotes, im Rahmen des Diffusionslötprozesses, eine vollständige Umwandlung des flüssigen Lotmaterials in intermetallische Phasen, innerhalb sehr kurzer Lötprozesszeiten, welche mit den Lötzeiten des herkömmlichen Lötprozesses vergleichbar sind, möglich wird.

Nachfolgend soll nun die erfindungsgemäße Lösung an einem Ausführungsbeispiel in Verbindung mit 5 Figuren näher erläutert werden.

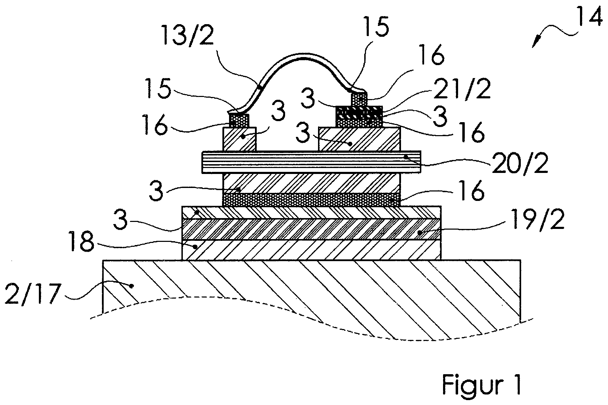

Die Figur 1 zeigt den schematischen Aufbau eines Halbleiterleistungsschalters.

Der Chip / Halbleiterbaustein 21 wird auf eine Leiterbahn, d.h. eine metallische Oberflächenschicht 3 gelötet, welche von einer elektrisch isolierenden Schicht aus Keramik (DCB), dem keramisches Substrat 20, getragen wird. Dessen obere Seite wird mit einer anderen, ebenfalls auf dem Substrat befindlichen Leiterbahn / metallischen Oberflächenschicht 3 verbunden, was gewöhnlich in einem Bondprozess mit dünnen Aluminium- oder Kupferdrähten / Leiterbändern 13 realisiert wird. Das keramisches Substrat 20 wird auf eine Bodenplatte 19 gelötet, welche auf einer Wärmesenke / einem Kühlkörper 17 montiert wird. Alle zu verbindenden Oberflächen / Oberflächenschichten 3 müssen metallisch sein, die Verbindungszonen 16 selbst müssen einen möglichst effektiven Wärmefluss zur Wärmesenke hin gewährleisten.

Nachfolgend soll der Einsatz der erfindungsgemäßen Lötfolie 1 in Verbindung mit dem Fügeprozess, einem Diffusionslötprozess zum Aufbau des in der Figur 1 dargestellten Halbleiterleistungsschalter näher erläutert werden.

Dabei wird die erfindungsgemäße bleifreie Lötfolie 1 in der Bauform als Lotverbundwerkstoff 4 einerseits zum Erzielen eines Stromanschlusses des Halbleiterbausteins 21 mit einem Leiterband 13, wie andererseits auch zum Löten des Halbleiterbausteins 21 auf die DCB, dem keramischen Substrat 20, als Lotformteil 12 eingesetzt.

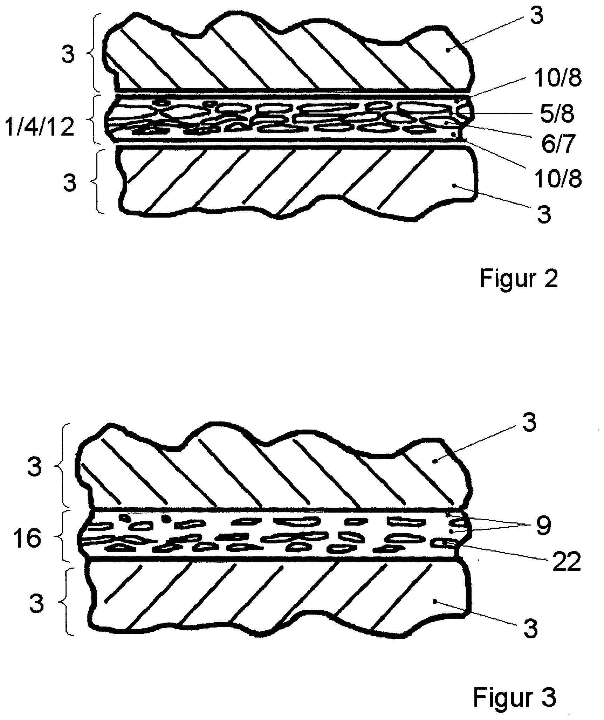

Die Figur 2 zeigt in einer Schnittdarstellung die Anordnung der Lötfolie 1 in der Ausführungsform als Lotverbundwerkstoff 4 zwischen den zu verbindenden metallischen Oberflächenschichten 3 der Fügepartner mit gleichen oder verschiedenartigen metallischen Oberflächen/Oberflächenschichten 3. Im Lotverbundwerkstoff 4 sind Partikel 6 aus Kupfer dispers in einer bleifreien Sn-Weichlotmatrix 5 verteilt, wobei der Abstand zwischen den Partikeln 6 kleiner oder gleich 10 µm ist und die oberste und unterste Schicht, die Mantelschichten 10, jeweils vom Weichlot 8 gebildet wird.

Die Figur 3 stellt die Anordnung gemäß der Figur 2 nach dem Lötprozess schematisch dar. Das Sn-Weichlot 8 ist vollständig in intermetallische Verbindungen / intermetallische Phasen 9 mit einem Schmelzpunkt höher als 400°C umgewandelt, darin dispers verteilt befinden sich Reste (Restmetall 22) der hochschmelzenden Metall-Partikel 6 aus Cu. Dadurch wird gewährleistet, dass die gesamte Verbindungszone 16 erst bei Temperaturen über 400°C schmilzt und zudem neben der hohen elektrischen Leitfähigkeit eine sehr gute Wärmeleitfähigkeit gewährleistet.

Nachfolgend wird die erfindungsgemäße bleifreie Lötfolie in der Bauform als Mehrschichtlötfolie 11 zum Systemlöten, d.h. hier zur Erzielung einer Lotverbindung zwischen der DCB, dem keramischen Substrat 20 und der Bodenplatte 19 eingesetzt.

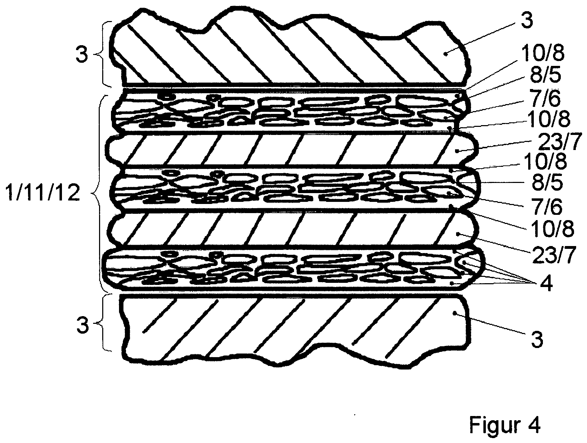

Die Figur 4 zeigt in einer schematischen Schnittdarstellung die Anordnung der Lötfolie 1 in einer möglichen Ausführungsform als Mehrschichtlötfolie 11, in Form von Lotformteilen 12, in ihrer Lage bezüglich der Fügepartner, d.h. zwischen den zu verbindenden gleichen oder verschiedenartigen metallischen Oberflächenschichten 3 der zu fügenden Bauteile.

In dieser Mehrschichtlötfolie 11 sind zwei Schichten einer hochschmelzenden Metallkomponente 7, wie erfindungsgemäß Cu, die Zwischenschichten 23, zwischen drei Schichten des Lotverbundwerkstoffes 4 angeordnet. Im Lotverbundwerkstoff 4 sind Cu-Partikel 6 dispers in einer bleifreien Sn-Weichlotmatrix 5 verteilt, wobei der Abstand zwischen den Partikeln 6 kleiner oder gleich 10µm ist, wobei die oberste und unterste Schicht der Mehrschichtlötfolie 11, die Mantelschichten 10, wieder jeweils vom Weichlot 8 gebildet wird.

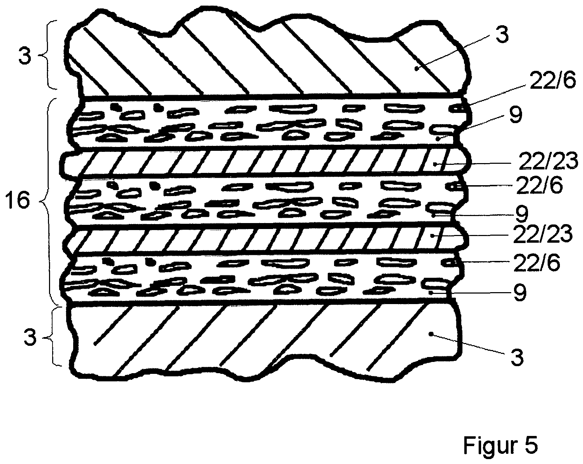

Die Figur 5 zeigt nun schematisch die Anordnung gemäß Figur 4 nach dem Lötprozess. In den Materialschichten aus Lotverbundwerkstoff 4 ist das Sn-Weichlot 8 vollständig in intermetallische Verbindungen / intermetallische Phasen 9 mit einem Schmelzpunkt höher als 400°C umgewandelt, darin dispers verteilt befinden sich aber auch Reste der hochschmelzenden Metall-Partikel 6 Cu.

Dazwischen, durch die intermetallischen Phasen 9 verbunden, befindet sich das Restmetall 22 der Zwischenschichten 23 aus der hochschmelzenden Metallkomponente 7 wie erfindungsgemäß Cu, wodurch die gesamte Verbindungszone 16 erst bei Temperaturen über 400°C schmilzt und eine sehr gute Wärmeleitfähigkeit, wie auch eine angepasste resultierende thermische Ausdehnung derselben gewährleistet.

Nachfolgend soll nun der Lötprozess zur Herstellung der in den Figuren 3 und 5 dargestellten Verbindungszonen 16 aus der erfindungsgemäßen bleifreien Lötfolie 1 näher erläutert werden.

Zum Chiplöten werden die Halbleiterbausteine 21, wie z.B. Si-Chips, SiC Chips oder IGBT-Module mit einer DCB, einem keramischen Substrat 20 verlötet.

Dabei sind die Halbleiterbausteine 21 gewöhnlich mit Ni oder Ni(Ag) beschichtet, die DCB, das keramische Substrat 20 ist mit einer Oberflächenschicht 3 aus Cu und oft zusätzlich noch mit Ni beschichtet. Bisher werden zum Chiplöten üblicherweise hoch bleihaltige Lotlegierungen verwendet, da deren Schmelztemperatur bei 290°C bis 305°C liegt und die so geschaffene Lotverbindung aufgrund der in der Serienproduktion üblichen Stufenlötung im zweiten Lötprozess zur Systemlötung bei Temperaturen von über 240°C nicht wieder aufschmelzen soll. Üblicherweise wird in der Serienproduktion in einer ersten Stufe die Chiplötung durchgeführt, und in einer zweiten Stufe erfolgt das Systemlöten mit einem bleifreien Lot. Da das hoch bleihaltige Lot eine höhere Schmelztemperatur aufweist, als das bleifreie Lot, wird durch diese Stufenlötung in der beschriebenen Reihenfolge vermieden, dass die Chip-Lotverbindung während des Systemlötens aufschmilzt.

Gemäß der vorliegenden Erfindung wird zum Chiplöten ein Lotformteil 12 aus Lotverbundwerkstoff 4 mit einer Sn-Weichlotmatrix 5 und dispers darin verteilten Kupfer-Partikeln 6 verwendet, wobei der Lotverbundwerkstoff 4 eine den metallischen Oberflächenschichten 3 der zu fügenden Bauteile 2 benachbarte äußere Mantelschicht 10 aus Weichlot 8 aufweist, welche einerseits an der metallischen Oberfläche 3 des Chips / Halbleiterbausteines 21 und andererseits des Lotverbundwerkstoffs 4 an der metallischen Oberfläche/Oberflächenschichten 3 der DCB / des keramischen Substrats 20 anliegt, d.h. mit diesen in Kontakt kommt.

Gegenüber den in Verbindung mit den hoch bleihaltigen Loten durchgeführten Chiplötverfahren ist bei Einsatz der erfindungsgemäßen Lösung eine wesentlich niedrigere Prozesstemperatur möglich, so dass hier die in einem Bleifrei-Weichlötprozess übliche Erwärmung bis 240°C ausreichend ist.

Das Sn-Weichlot 8 schmilzt bei ca. 220°C, die flüssige Phase reagiert mit den metallischen Oberflächen / Oberflächenschicht 3 der benachbarten Bauteile 2 und löst innerhalb von 2 min so viel dispergiertes Kupfer, dass sich die flüssige Phase vollständig in die festen intermetallischen Phasen 9 , d.h. in CuSn3 und Cu6Sn5, umwandelt.

Es entsteht so die porenfreie Verbindungszone 16, deren Schmelztemperatur über 400°C liegt.

Zum Systemlöten wird die DCB, das keramische Substrat 20, welches nun bereits den Chip / den Halbleiterbaustein 21 trägt, mit der Bodenplatte 19 verlötet. Dabei ist die Bodenplatte 19 gewöhnlich mit einer Oberflächenschicht 3 aus Cu, Ni, Ni(P) oder Ni(Ag) beschichtet, die DCB / das keramische Substrat 20 ist mit einer Oberflächenschicht 3 aus Cu, Ni, Ni(P) oder Ni(Ag) beschichtet.

Erfindungsgemäß wird zum Systemlöten ein Lotformteil 12 aus Mehrschichtlötfolie 11 in einem Bleifrei-Weichlötprozess verarbeitet. Der Einsatz der Mehrschichtlötfolie 11 bietet die Möglichkeit, über den Schichtaufbau Mehrschichtlötfolie 11 die mechanische Flexibilität der nach dem Lötprozess entstehenden Verbindungszone 16 zu erhöhen. Im vorliegenden Ausführungsbeispiel besteht das Lotformteil 12 aus Schichten eines Lotverbundwerkstoffes 4 mit einer Sn-Weichlotmatrix 5 und dispers in dieser Sn-Weichlotmatrix 5 verteilten Partikeln 6 einer Kupfer-Metallkomponente 7, wobei sich diese Schichten mit Schichten einer hochschmelzenden Metallkomponente 7, wie z.B. Kupfer abwechselt, die äußeren Schichten des Lotverbundwerkstoffes 4, die Mantelschichten 10, bestehen nur aus dem Sn-Weichlot 8. Diese äußeren Schichten des Lotverbundwerkstoffes 4 kommen mit den metallischen Oberflächen / Oberflächenschichten 3 des Substrats 20 und der Bodenplatte 19, d.h. der Bauteile 2, in Kontakt.

Das Sn-Weichlot 8 schmilzt wiederum bei ca. 220°C. Die nun flüssige Mantelschicht 10 bildet mit den Metallisierungen des Substrats 20 und der Bodenplatte 19 die intermetallischen Phasen 9 CuSn3 und Cu6Sn5.

Gleichzeitig löst innerhalb der Mehrschichtlötfolie 11 das nun ebenfalls flüssige Weichlot 8 innerhalb von 2 min so viel dispergiertes Kupfer (die Partikel 6 der Metallkomponente 7), dass sich dieses vollständig in die festen intermetallischen Phasen CuSn3 und Cu6Sn5 umwandelt. Dieselben Phasen werden zudem an der Grenzfläche mit den Zwischenschichten 23 der hochschmelzenden Metallkomponente 7 gebildet. Es entsteht so im Bereich der ursprünglich angeordneten Mehrschichtlötfolie 11 nach dem Lötprozess eine porenfreie Verbindungszone 16, deren Schmelztemperatur über 400°C liegt, und welche, bedingt durch verbleibende metallische Restschichten 22, einen angepassten resultierenden thermischen Ausdehnungskoeffizienten aufweist.

Im Stand der Technik wird die Chipoberseite üblicherweise in einem Ultraschallschweißprozess durch feine Aluminium- oder Kupferdrähte mit der Leiterbahn auf dem Substrat verbunden (gebondet). Dieses Fügeverfahren kann mittels der erfindungsgemäßen Lötfolie ebenfalls durch einen Diffusionslötprozess ersetzt werden, der analog zu den vorgenannten Lötprozessen verläuft.

Erfindungsgemäß wird zum Kontaktieren des Chips ein Leiterband 13 aus einem elektrischen Leiter wie Aluminium oder Kupfer verwendet, auf dessen beide zu fügenden Anschlussflächen zuvor der Lotverbundwerkstoff 4 dergestalt aufgebracht wurde, dass deren äußere, aus Sn-Weichlot 8 bestehende Schicht die metallische Oberflächenschicht 3 des Chip/ Halbleiterbausteins 21 einerseits und die metallische Oberflächenschicht 3 des DCB/ Substrates kontaktiert. Bei Erwärmung auf die entsprechende Temperatur eines Bleifrei-Weichlötprozesses schmilzt das Weichlot 8 des Lotverbundwerkstoffes 4.

Im Inneren des Lotverbundwerkstoffes 4 löst das nun flüssige Weichlot 8 innerhalb von 2 min so viel dispergiertes Kupfer (die Partikel 6 der Metallkomponente 7), dass es sich vollständig in die festen intermetallischen Phasen CuSn3 und Cu6Sn5 umwandelt. An der Grenzfläche zu den Metallisierungen (metallische Oberflächenschichten 3) der Chipoberseite und des Substrats bilden sich ebenfalls die intermetallischen Phasen CuSn3 und Cu6Sn5. Somit entsteht auch hier eine den in Chip- und Systemlötungen gleichwertige Verbindungszone 16.

### Bezugszeichenzusammenstellung

- 1: Lötfolie
- 2: Bauteile
- 3: Oberflächenschicht
- 4: Lotverbundwerkstoff
- 5: Weichlotmatrix
- 6: Partikel
- 7: Metallkomponente
- 8: Weichlot
- 9: Intermetallische Phasen
- 10: Mantelschicht
- 11: Mehrschichtlötfolie
- 12: Lotformteil
- 13: Leiterband
- 14: Produkt
- 15: Fügestellen
- 16: Verbindungszone
- 17: Kühlkörper
- 18: thermische Interface-Materialien
- 19: Bodenplatte
- 20: keramisches Substrat (DCB)
- 21: Halbleiterbaustein (Chip)
- 22: Restmetall (hochschmelzend)
- 23: Zwischenschicht (hochschmelzend)

## Patentansprüche

1. Bleifreie Lötfolie (1) zum Diffusionslöten, um metallische Bauteile (2) und/oder metallisierte/metallbeschichtete Bauteile (2), d.h. metallische Oberflächenschichten (3) benachbarter Bauteile (2), miteinander zu verbinden, **dadurch gekennzeichnet,**
- **dass** die bleifreie Lötfolie (1) aus einem kompakten Lotverbundwerkstoff (4) besteht, und dieser kompakte, d.h. stoffschlüssige, feste, Lotverbundwerkstoff (4) so aufgebaut ist, dass in einer bleifreien Weichlotumgebung, einer Weichlotmatrix (5) aus Zinn (Sn), Partikel (6) einer hochschmelzenden Metallkomponente (7), einer Hartlotkomponente aus Kupfer (Cu) und/oder Nickel (Ni), dispers verteilt derart angeordnet sind, dass jeder der Partikel (6) vollständig vom bleifreien Weichlot (8) umgeben ist, um in einem gebräuchlichen Weichlötprozess, mit einem für das bleifreie Weichlöten typischen Lötprofil, eine vollständige Umwandlung des Weichlotes (8) der Weichlotmatrix (5) in intermetallische Phasen (9) zu bewirken, welche eine Schmelztemperatur von höher als 400°C aufweisen, und
- **dass** die in der Weichlotmatrix (5) dispers verteilten Partikel (6) der hochschmelzenden Metallkomponente (7) in Richtung der Folienstärke eine Dicke von 3 µm bis 20 µm aufweisen, wobei die Abstände der Partikel (6) zueinander in der Weichlotmatrix (5) 1 µm bis 10 µm betragen, und jeder der Partikel (6) der hochschmelzenden Metallkomponente (7) allseitig von einer 1 µm bis 10 µm starken Schicht des bleifreien Weichlotes (8) umhüllt ist, und
- **dass** der Weichlotanteil, die Weichlotmatrix (5), im Verhältnis zum Anteil an hochschmelzender Metallkomponente (7) nicht höher liegt, als in den aufzubauenden intermetallischen Phasen (9) erforderlich, wobei dieses Verhältnis des prozentualen Anteils der in dem Lotverbundwerkstoff (4) angeordneten Partikel (6) der hochschmelzenden Metallkomponenten (7) zum prozentualen Anteil des Weichlotes (8) der die Partikel (6) umgebenden bleifreien Weichlotmatrix (5), gemäß der stöchiometrischen Formel der aus den jeweiligen Ausgangsmaterialien zu bildenden intermetallischen Phasen (9) so ermittelt wird, dass stets alles Weichlot (8) der bleifreien Weichlotmatrix (5) in die jeweils aufzubauenden intermetallischen Phasen (9) umgewandelt wird, und
- **dass** die Gesamtdicke der bleifreien Lötfolie (1) 20 µm bis 0,5 mm beträgt, und
- **dass** die Lötfolie (1), der Lotverbundwerkstoff (4), eine den metallischen Oberflächenschichten (3) der zu fügenden Bauteile (2) benachbarte äußere Mantelschicht (10) aufweist, deren Schichtdicke von 2 µm bis10 µm beträgt und die aus Weichlot (8) besteht.

2. Verfahren zur Herstellung einer bleifreien Lötfolie (1) zum Diffusionslöten nach Anspruch 1, um metallische Bauteile (2) und/oder metallisierte/metallbeschichtete Bauteile (2), d.h. metallische Oberflächenschichten (3) benachbarter Bauteile (2), miteinander mittels eines Walzverfahrens zu verbinden, **dadurch gekennzeichnet,**
- **dass** zur Herstellung der bleifreien Lötfolie (1), das Walzplattierverfahren vielfach wiederholt und dispergierend so eingesetzt wird, dass ein kompakter Lotverbundwerkstoff (4) entsteht, bei dem in einer bleifreien Weichlotumgebung, einer Weichlotmatrix (5), Partikel (6) einer hochschmelzenden Metallkomponente (7), einer Hartlotkomponente, dispers verteilt derart angeordnet sind, dass jeder der Partikel (6) vollständig vom bleifreien Weichlot (8) umgeben ist, und
- **dass** zur Herstellung des Lotverbundwerkstoffes (4) zunächst entsprechend der vorgesehenen/beabsichtigten prozentualen Zusammensetzung des Lotverbundwerkstoffes (4) Weichlot- und Metallkomponenten abwechselnd zu einem Schichtverbund mittels dem Walzplattierverfahren so gefügt werden, dass die Metallkomponente stets beidseitig mit der Weichlotkomponente in Verbindung kommt, wobei die einzusetzenden Schichtdicken der Komponenten insgesamt so im Verhältnis zueinander stehen, dass im späteren Lötprozess der Weichlotanteil vollständig in die intermetallische Phase eingebaut wird, und
- **dass** mit dem einmal plattierten Schichtverbund nachfolgend vielfach wiederholt weitere Walzplattierschritte ausgeführt werden, bei denen das jeweils plattierte Material mit sich selbst plattiert wird, so dass sich die Zahl der Schichten im Material erhöht, deren Stärke jedoch gleichzeitig reduziert wird, und
- **dass** die Anzahl der Walzplattierschritte in Abhängigkeit von der gewählten Werkstoffkombination aus Weich- und Hartlotkomponente und der gewünschten Gesamtdicke für die Lotformteile bis; zum fertigen Lotverbundwerkstoff (4) vielfach wiederholt werden, so
- **dass** in Folge des vielfach wiederholten Walzplattierens des Schichtverbundes eine Durchmengung der Einzelkomponenten im festen Zustand erfolgt, und
- **dass** dabei durch Aufreißen der Schichten einer der beiden Komponenten dann deren Bruchstücke in der anderen, der weicheren Komponente dispers verteilt, d.h. dispergiert werden, so
- **dass** durch das vielfach wiederholte dispergierende Walzplattieren eine Struktur mit Partikelabständen kleiner oder gleich 10 µm entsteht.

3. Bleifreie Lötfolie (1) zum Diffusionslöten nach Anspruch 1, **dadurch gekennzeichnet,**
- **dass** die Lötfolie (1) als Mehrschichtlötfolie (11) aufgebaut ist, und
- **dass** die einzelnen Schichten der Mehrschichtlötfolie (11) abwechselnd aus dem in Anspruch 1 beschriebenen Lotverbundwerkstoff (4) und aus 2 µm bis 100 µm starken Schichten einer hochschmelzenden Metallkomponente (7), einer Zwischenschicht (23), bestehen, und
- **dass** die Mehrschichtlötfolie (11) eine den metallischen Oberflächenschichten (3) der zu fügenden Bauteile (2) benachbarte äußere Mantelschicht (10) aufweist, deren Schichtdicke von 2 µm bis 10 µm beträgt und die aus Weichlot (8) besteht, und
- **dass** die Gesamtdicke der Mehrschichtlötfolie (11) 40 µm bis 1,0 mm beträgt.

4. Verfahren zur Herstellung einer bleifreien Lötfolie (1) zum Diffusionslöten nach Anspruch 3, **dadurch gekennzeichnet,**
- **dass** die Lötfolie (1) als Mehrschichtlötfolie (11) aufgebaut ist, deren einzelne Schichten mittels Walzplattieren derart miteinander verbunden werden, dass diese einzelnen Schichten der Mehrschichtlötfolie (11) abwechselnd aus dem in Anspruch 1 beschriebenen Lotverbundwerkstoff (4) und aus Schichten einer hochschmelzenden Metallkomponente (7), einer Zwischenschicht (23), bestehen, wobei die Mehrschichtlötfolie (11) eine den metallischen Oberflächenschichten (3) der zu fügenden Bauteile (2) benachbarte äußere Mantelschicht (10) aufweist die aus Weichlot (8) besteht.

5. Verwendung einer bleifreien Lötfolie (1) zum Diffusionslöten nach einem der Ansprüche 1 oder 3, **dadurch gekennzeichnet,**
- **dass** diese bleifreie Lötfolie (1) als Lotformteil (12) in einem Bleifrei-Weich-Lötprozesse eingesetzt wird und dabei, unter Einsatz eines für das bleifreie Weichlöten typischen Lötprofils, die benachbarten Bauteile (2) so miteinander verbindet, dass die Verbindungszone (16) nach dem Lötprozess eine Wiederaufschmelztemperatur von höher als 400°C hat.

6. Verwendung einer bleifreien Lötfolie (1) zum Diffusionslöten nach Anspruch 1 oder 3, **dadurch gekennzeichnet,**
- **dass** die bleifreie Lötfolie (1) an den Fügestellen (15) eines metallischen Leiterbandes (13), welches im zu fügenden Produkt (14) als elektrischer Leiter dient, partiell so angeordnet ist, dass das so partiell an seinen Fügestellen (15) beschichtete Leiterband (13) in einem Bleifrei-Weichlötprozess die mit dem Leiterband (13) zu verbindenden Bauteile (2), an den Fügestellen (15) so miteinander verbindet, dass die Verbindungszone (16) nach dem Bleifrei-Weichlötprozess eine Wiederaufschmelztemperatur von mehr als 400°C hat.

## Claims

1. Lead-free Solder foil (1) for diffusion soldering, for connecting metallic Structural components (2) and/or for connecting metallised/metal-coated Structural components (2), i.e. for connecting metallic Surface coatings (3) of adjacent Structural components (2) to one another, **characterised in,**
- **that** the lead-free Solder foil (1) is comprised of a compact Composite solder material (4), and this compact, i.e. firmly-bonded, rigid, Composite solder material (4) is composed in such a way, that in a lead-free soft solder environment, of a Soft solder matrix (5) made of tin (Sn), Particles (6) of a high-melting point Metallic component (7), of a hard soldering component made of copper (Cu) and/or nickel (Ni), are distributed and dispersed, such that each of the Particles (6) is surrounded completely by lead-free Soft solder (8), in order that in a customary soldering process, with typical soldering profiles for lead-free soldering, full conversion of lead-free Soft solder (8) of the Soft solder matrix (5) is effected in Intermetallic Phases (9), which have a melting temperature of over 400°C, and
- **that** the dispersed Particles (6) distributed in the Soft solder matrix (5) of the high-melting temperature Metallic component (7) display a thickness of 3 µm to 20 µm in the direction of the foil thicknesses, wherein the separation distances of the Particles (6) from one another in the Soft solder matrix (5) are 1 µm to 10 µm, and each of the Particles (6) of the high-melting temperature Metallic components (7) are enveloped on all sides by a 1 µm to 10 µm thick layer of the Soft solder (8), and
- **that** the proportion of soft solder, the Soft solder matrix (5), in relation to the proportion of high-melting temperature Metallic component (7) is not higher than is necessary during synthesizing of Intermetallic Phases (9), wherein this ratio of the percentage of Particles (6) arranged in Composite solder material (4) of the high-melting temperature Metallic components (7) to the percentage share of Soft solder (8) of the lead-free Soft solder matrix (5) which surrounds the Particles (6) in accordance with the stoichiometric formula from the Intermetallic Phases (9) to be formed from the respective starting materials which must be determined in such a way, that the entirety of the Soft solder (8) of the lead-free Soft solder matrix (5) is converted in the respective built-up intermetallic phases (9), and
- **that** the entire thickness of the lead-free Solder foil (1) is 20 µm to 0,5 mm, and
- **that** the Solder foil (1) and the Composite solder material (4), have a Jacket sheath (10) alongside the metallic Surface coating (3) of the Structural components (2) which must be joined, whose coating thickness is between 2 µm and 10 µm and is composed of Soft solder (8).

2. Method for producing a lead-free Solder foil (1) for diffusion soldering according to Claim 1, in order to join metallic Structural components (2) and/or metalized/metal-coated Structural components (2), i.e. metallic Surface coating (3) of neighbouring Structural components (2) to one another, by means of a rolling process, **characterized in,**
- **that** the rolling process for producing lead-free Solder foil (1) is repeated frequently and is employed in a dispersing manner in such a way, that a compact Composite solder material (4) is produced, in which lead-free soft solder environment of a Soft solder matrix (5), Particles (6) of a high-melting temperature Metallic component (7), Particles (6) of a hard solder component are distributed in a disperse manner, so that each of the Particles (6) is surrounded entirely by lead-free Soft solder (8), and
- **that** for producing a Composite solder material (4), first of all soft solder and metallic components are alternately joined together into a composite coating corresponding to the specified/intended percentage composition of the Composite solder material (4), using a roller cladding process in such a way, that both sides of the metallic component are always in contact with the soft solder component, wherein the coating thicknesses of the components to be employed are overall in a ratio to one another in such a manner, that the soft solder proportion is installed completely into the intermetallic phase during the subsequent welding process, and
- **that** once clad and plated with the composite coating, subsequently multiple repeats of roller cladding steps are carried out, in which cladding material in each case is clad with itself in such a manner, that the number of layers in the material increases, however whose thickness is at the time is reduced, and
- **that** the number of the roller cladding steps is repeated many times dependent on the combination of materials of soft and hard soldering components selected and the desired overall thickness for the pre-formed solder pieces through to finished Composite solder material (4), so
- **that** as a consequence of frequently repeated roller cladding of the composite coating thorough mixing of the individual components occurs in a solid state, and
- **that** then through tearing off layers of one of the two components, fragments of debris of it are then distributed diversely in the other, softer component, i.e. dispersed, so
- **that** through the frequently repeated dispersed roller cladding, a structure with particle separations of smaller than or equal to 10 µm arises.

3. Lead-free Solder foil (1) for diffusion soldering according to Claim 1, **characterized in,**
- **that** the Solder foil (1) is built up as a Multi-layer foil (11), and
- **that** the individual layers of the Multi-layer foil (11) are alternately comprised of Composite solder material (4) described in Claim 1 and 2 µm to 100 µm thick layers of a high-melting temperature Metallic component (7), and an intermediate coating layer (23), and
- **that** the Multi-layer foil (11) has a Jacket sheath (10) which is adjacent to the metallic Surface coating (3) of the Structural components (2) which must be joined, and whose coating thickness is between 2 µm and 10 µm and which is comprised of Soft solder (8), and
- **that** the overall thickness of the Multi-layer foil (11) is from 40 µm to 1,0 mm.

4. Method for producing a lead-free Solder foil (1) for diffusion soldering according to Claim 3, **characterized in,**
- **that** the Solder foil (1) is built up as a Multi-layer foil (11), whose individual layers are joined to one another by means of roller cladding in such a way, that these individual layers of the Multi-layer foil (11) are alternately comprised of the Composite solder material (4) described in Claim 1 and of layers of a high-temperature Metallic component (7), of an Intermediate coating layer (23), wherein the Multi-layer foil (11) has a Jacket sheath (10) comprised of Soft solder (8) which adjoins the metallic Surface coating (3) of the Structural components (2) which must be joined.

5. Use of a lead-free Solder foil (1) for diffusion soldering according to one of the Claims 1 or 3, **characterized in,**
- **that** this lead-free Solder foil (1) is used as a Pre-formed solder piece (12) in a lead-free soft soldering process and in this way, through use of a typical solder profile for lead-free soft soldering, the neighbouring Structural components (2) are connected to one another in such a way, that the Connecting zone (16) according to the welding process has a remelting temperature in excess of 400°C.

6. Use of a lead-free Solder foil (1) for diffusion soldering according to one of the Claims 1 or 3, **characterized in,**
- **that** the lead-free Solder foil (1) is partially arranged in such a way at the Jointing points (15) of a metallic Conductor strip (13), which serves as an electrical conductor in the Product (14) which must be joined, that the Conductor strip (13) partially coated in this way at its Jointing points (15) connects the Structural components (2), which must be connected to the Conductor strip (13) are connected to one another in that the Connecting zone (16) has a remelting temperature of more than 400°C according to the lead-free soft soldering process.

## Revendications

1. Feuille de brasage (1) sans plomb destinée au brasage-diffusion et servant à relier ensemble des éléments (2) métalliques et/ou des éléments (2) métallisés/à revêtement métallique, c'est-à-dire des couches de surface (3) d'éléments (2) voisins, **caractérisée par le fait**
- **que** la feuille de brasage (1) sans plomb se compose d'un matériau composite de brasage (4) compact, et que ce matériau composite de brasage (4) compact, c'est-à-dire robuste, en liaison avec le matériau, est conçu de telle manière que, dans un environnement de brasage tendre sans plomb, dans une matrice de brasage tendre (5) en étain (Sn), des particules (6) d'un composant métallique (7) réfractaire, d'un composant de brasage dur en cuivre (Cu) et/ou nickel (Ni), sont réparties de manière dispersée de telle manière que chacune des particules (6) soit entièrement entourée de brasage tendre (8) sans plomb, pour, dans le cadre d'un processus de brasage tendre courant, avec un profil de brasage typique du brasage tendre sans plomb, provoquer une transformation complète du brasage tendre (8) de la matrice de brasage tendre (5) dans des phases intermétalliques (9), lesquelles présentent une température de fusion supérieure à 400°C, et
- **que** les particules (6) du composant métallique (7) réfractaire, réparties de manière dispersée dans la matrice de brasage tendre (5), présentent en direction de l'épaisseur de feuille une épaisseur de 3 µm à 20 µm, les distances des particules (6) entre elles dans la matrice de brasage tendre (5) étant de 1 µm à 10 µm, et chacune des particules (6) du composant métallique (7) réfractaire étant recouverte des tous les côtés par une couche du brasage tendre (8) sans plomb de 1 µm à 10 µm d'épaisseur, et
- **que** la proportion de brasage tendre, la matrice de brasage tendre (5), par rapport à la proportion de composant métallique (7) réfractaire n'est pas supérieure à ce qui est nécessaire dans les phases intermétalliques (9) à réaliser, ce rapport de la proportion en pourcentage des particules (6) des composants métalliques (7) réfractaires disposées dans le matériau composite de brasage (4) relativement au rapport à la proportion en pourcentage du brasage tendre (8) sans plomb de la matrice de brasage tendre (5) sans plomb entourant les particules (6) étant déterminé selon la formule stœchiométrique résultant des phases intermétalliques (9) à réaliser à partir des matériaux initiaux correspondants, de telle manière que tout le brasage tendre (8) de la matrice de brasage tendre (5) sans plomb soit converti en permanence dans les phases intermétalliques (9) à réaliser, et
- **que** l'épaisseur totale de la feuille de brasage (1) sans plomb est de 20 µm à 0,5 mm, et
- **que** la feuille de brasage (1), le matériau composite de brasage (4), présente une couche de placage (10) extérieure voisine des couches de surface (3) métalliques des éléments (2) à raccorder, l'épaisseur de couche étant de 2 µm à 10 µm et se composant de brasage tendre (8).

2. Procédé de fabrication d'une feuille de brasage (1) sans plomb destinée au brasage-diffusion selon l'exigence 1 servant, au moyen d'un procédé de laminage, à relier des éléments (2) métalliques et/ou métallisés/à revêtement métallique, c'est-à-dire de couches de surface (3) d'éléments (2) voisins, **caractérisé par le fait**
- **que**, pour la fabrication de la feuille de brasage (1) sans plomb, le procédé de placage-laminage est répété plusieurs fois et mis en service de manière dispersive afin qu'un matériau composite de brasage (4) compact se forme, pour lequel, dans un environnement de brasage tendre sans plomb, dans une matrice de brasage tendre (5), des particules (6) d'un composant métallique (7) réfractaire, d'un composant de brasage dur, réparties de manière dispersée de telle façon que chacune des particules (6) soit entièrement entourée de brasage tendre (8) sans plomb, et
- **que**, pour la fabrication du matériau composite de brasage (4), tout d'abord selon la composition en pourcentage prévue/envisagée du matériau composite de brasage (4), des composants de brasage tendre et des composants métalliques sont ajoutés en alternance par procédé de placage-laminage pour former une liaison de couches, de manière à ce que le composant métallique soit toujours en liaison des deux côtés avec le composant de brasage tendre, les épaisseurs de couche des composants à mettre en œuvre étant en tout en relation en elles de façon à ce que la proportion de brasage tendre soit complètement intégrée dans la phase intermétallique lors du processus de brasage ultérieur, et
- **que**, avec la liaison de couches une fois plaquée une fois, d'autres étapes de placage-laminage sont réalisées plusieurs fois par la suite, lors desquelles le matériau respectivement plaqué est plaqué avec lui-même, de manière à ce que le nombre de couches dans le matériau soit augmenté, dont l'épaisseur est cependant simultanément réduite, et
- **que** le nombre d'étapes de placage-laminage en fonction de la combinaison de matériaux choisie, formée de composants de brasage tendre et de brasage dur et de l'épaisseur totale souhaitée pour les préformes de brasage est répété plusieurs fois jusqu'au matériau composite de brasage (4) achevé, de telle manière
- **que**, à la suite du placage-laminage de liaison de couches répété plusieurs fois, un brassage des composants individuels est effectué à l'état solide,
- **que**, à la suite de la déchirure des couches de l'un des deux composants, leurs fragments sont alors répartis de façon dispersée dans l'autre composant plus tendre, de telle manière
- **que**, en raison du placage-laminage dispersé plusieurs fois répété, une structure présentant des distances entre particules inférieures ou égales à 10 µm se forme.

3. Feuille de brasage (1) sans plomb destinée au brasage-diffusion selon l'exigence 1, **caractérisée par le fait,**
- **que** la feuille de brasage (1) est conçue comme feuille de brasage à plusieurs couches (11), et
- **que** les différentes couches de la feuille de brasage à plusieurs couches (11) se composent en alternance du matériau composite de brasage (4) décrit à l'exigence 1 et de couches d'un composant métallique (7) réfractaire, d'une couche intermédiaire (23), dont l'épaisseur est comprise entre 2 µm et 100 µm, et
- **que** la feuille de brasage à plusieurs couches (11) présente une couche de placage (10) extérieure et voisine des couches de surface (3) métalliques des éléments (2) à ajouter, dont l'épaisseur de couche est comprise entre 2 µm et 10 µm et composée de brasage tendre (8), et
- **que** l'épaisseur totale de la feuille de brasage à plusieurs couches (11) est comprise entre 40 µm et 1,0 mm.

4. Procédé de fabrication d'une feuille de brasage (1) sans plomb destinée au brasage-diffusion selon l'exigence 3 **caractérisé par le fait,**
- **que** la feuille de brasage (1) est conçue comme feuille de brasage à plusieurs couches (11), dont les différentes couches sont reliées entre elles par placage-laminage de telle manière que ces différentes couches de la feuille de brasage à plusieurs couches (11) se composent en alternance du matériau composite de brasage (4) décrit à l'exigence 1 et de couches d'un composant métallique (7) réfractaire, d'une couche intermédiaire (23), la feuille de brasage à plusieurs couches (11) présentant une couche de placage (10) extérieure et voisine des couches de surface (3) métalliques des éléments (2) à ajouter, et composée de brasage tendre (8).

5. Utilisation d'une feuille de brasage (1) sans plomb destinée au brasage-diffusion selon l'une des exigences 1 ou 3 **caractérisée par le fait,**
- **que** cette feuille de brasage (1) sans plomb est mise en œuvre comme préforme de brasage (12) dans un processus de brasage tendre sans plomb et en même temps, en utilisant un profil de brasage typique du brasage tendre sans plomb, lequel profil relie les éléments (2) ensembles de manière à ce que la zone de liaison (16) possède une température de refusion supérieure à 400°C après le processus de brasage.

6. Utilisation d'une feuille de brasage (1) sans plomb destinée au brasage-diffusion selon l'une des exigences 1 ou 3 **caractérisée par le fait,**
- **que** la feuille de brasage (1) sans plomb est disposée de manière partielle au niveau des joints (15) d'une bande conductrice (13) métallique, laquelle sert de conducteur électrique dans le produit (14) à ajouter afin que la bande conductrice (13) revêtue partiellement au niveau de ses joints (15) relie dans le cadre d'un processus de brasage tendre sans plomb les éléments (2) à raccorder à la bande conductrice (13) au niveau des joints (15) de manière à ce que la zone de liaison (16) possède une température de refusion supérieure à 400°C après le processus de brasage tendre sans plomb.
